(19) Europäisches Patentamt / European Patent Office / Office européen des brevets

(11) **EP 3 049 854 B1**

(12) **FASCICULE DE BREVET EUROPÉEN**

(45) Date de publication et mention de la délivrance du brevet:
**14.12.2022 Bulletin 2022/50**

(21) Numéro de dépôt: **14771904.1**

(22) Date de dépôt: **23.09.2014**

(51) Classification Internationale des Brevets (IPC):
**G02B 26/04** *(2006.01)*    **G02B 27/00** *(2006.01)*
**G02B 27/01** *(2006.01)*

(52) Classification Coopérative des Brevets (CPC):
**G02B 27/0172; G02B 26/04; G02B 27/0018;**
G02B 2027/0118; G02B 2027/012;
G02B 2027/0178

(86) Numéro de dépôt international:
**PCT/EP2014/070263**

(87) Numéro de publication internationale:
**WO 2015/044143 (02.04.2015 Gazette 2015/13)**

(54) **LUNETTES À AFFICHAGE DE DONNÉES MUNIES D'UN ÉCRAN ANTI-ÉBLOUISSEMENT**

DATENANZEIGEBRILLEN MIT BLENDSCHUTZSCHILD

DATA DISPLAYING GLASSES HAVING AN ANTI-GLARE SCREEN

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **26.09.2013 FR 1359271**

(43) Date de publication de la demande:
**03.08.2016 Bulletin 2016/31**

(73) Titulaire: **Valeo Vision**
**93012 Bobigny Cedex (FR)**

(72) Inventeurs:
• **HUE, David**
**F-95430 Butry sur Oise (FR)**
• **FLEURY, Benoist**
**F-94300 Vincennes (FR)**

(74) Mandataire: **Valeo Visibility**
**Service Propriété Industrielle**
**c/o Valeo Vision**
**34, rue Saint André**
**93012 Bobigny (FR)**

(56) Documents cités:
JP-A- 2004 233 908    US-A1- 2008 218 434
US-A1- 2013 113 973

**Description**

La présente invention concerne des lunettes à affichage de données munies d'un écran anti-éblouissement.

Dans le domaine des dispositifs optiques portatifs munis de technologies liées au domaine de l'information et de la communication de données, il est connu des lunettes à affichage de données capables d'afficher des données ou des informations visibles par l'utilisateur qui les porte. Les informations sont superposées, par transparence ou non, à la scène qu'observe normalement l'utilisateur à travers les lunettes.

Un tel dispositif d'affichage est un dispositif optronique permettant à un utilisateur de visualiser des informations, telles que du texte, des images ou de la vidéo, dans son champ de vision, sans avoir besoin de tourner ou de baisser la tête. Ainsi, l'utilisateur peut se déplacer et observer son environnement, en ayant simultanément accès à des informations.

Ces informations peuvent concerner directement des objets et lieux qui sont vus à travers les lunettes, l'image pouvant être même interactive en ajoutant par exemple des signaux lumineux liés à la scène observée. Elles peuvent également être indépendantes de la vision instantanée de l'utilisateur, et fournir par exemple un accès à internet et/ou à une messagerie électronique, que l'utilisateur peut consulter tout en gardant une vision lui permettant de se déplacer ou d'agir librement.

Il existe des lunettes munies de technologies d'affichage différentes.

Dans la demande de brevet FR_2_976_089, est décrite une paire de lunettes comportant un ou deux projecteurs disposés sur les branches. Les projecteurs projettent une image devant le porteur des lunettes, celui-ci ayant besoin d'un support devant lui pour les percevoir. Comme cela est décrit dans la demande FR 2_941_786, les verres des lunettes peuvent servir de support, afin notamment de concevoir des lunettes à réalité augmentée.

Des systèmes d'affichages plus sophistiqués permettent de faire apparaître les images en utilisant des verres munis de faces guidant la lumière dans le verre, une image formée est visible par l'utilisateur, tel que cela est montré dans le brevet US 7_751_122. D'autres systèmes d'affichages conventionnels sont divulgués dans les demandes de brevet US 2013/113973, US 2008/218434 et JP 2004 233908.

Cependant, la difficulté des systèmes actuels concerne la visibilité des informations lorsque la luminosité est importante. En effet, dans ces conditions, le contraste des informations les rend peu ou plus visibles si l'intensité des informations n'est pas suffisante par rapport à une lumière incidente d'intensité élevée. De plus, lorsqu'un utilisateur se déplace, la luminosité est amenée à changer régulièrement et rapidement.

En outre, pour une paire de lunettes munie de verres solaires, ces verres nuisent à la visibilité des informations, notamment si elles sont en couleur. De plus, les verres solaires ne sont pas compatibles avec toutes les technologies d'affichage de données.

Le but de l'invention est de remédier à ces inconvénients, et vise à fournir une paire de lunettes à affichage de données utilisable et adaptable à toutes les situations, quelle que soit l'intensité lumineuse ambiante.

Pour cela, les lunettes selon l'invention sont définies dans la revendication indépendante 1.

Avantageusement, une partie des rayons, préférentiellement une majorité, sont orientées de façon à atteindre directement l'œil de l'utilisateur sans traverser l'écran anti-éblouissement, une partie des rayons pouvant néanmoins rencontrer ledit écran anti-éblouissement.

Ainsi, les lunettes permettent, à partir d'un même support intégrant toutes les fonctions nécessaires, de lire les données affichées sur la zone d'affichage malgré une forte luminosité. En outre, quelle que soit la luminosité de la lumière incidente, elles offrent une adaptation du coefficient de transmission de l'écran pour que le porteur des lunettes perçoive une luminosité d'intensité modérée quelle que soit la situation.

De plus, comme l'écran anti-éblouissement transmet la lumière lorsque les moyens d'affichage affichent des données, la lumière provenant des données affichées sur la zone d'affichage et se dirigeant vers l'écran anti-éblouissement, passe à travers l'écran anti-éblouissement. Cette caractéristique évite que cette lumière se réfléchisse sur l'écran anti-éblouissement et pénalise, par conséquent, une perception correcte et une bonne lecture des données à cause d'une double image décalées.

La commande du coefficient de transmission de l'écran anti-éblouissement et/ou des moyens d'affichage pourra avoir lieu aussi bien à l'aide de moyens de commande intégrés aux lunettes que situés à distance. De même l'information relative à la luminosité pourra provenir d'un capteur situé sur les lunettes et/ou à distance.

Différents modes de réalisation de l'invention sont définis dans les revendications dépendantes.

L'invention sera mieux comprise à la lumière de la description suivante qui n'est donnée qu'à titre indicatif et qui n'a pas pour but de la limiter, accompagnée des dessins joints parmi lesquels :

- la figure 1 illustre de façon schématique, une vue en perspective d'une paire de lunettes à affichage de données selon l'invention,
- la figure 2 illustre de façon schématique, le principe de fonctionnement d'un mode de réalisation des lunettes selon l'invention,
- la figure 3 montre un graphique représentant la transmission de la lumière de l'écran anti-éblouissement comparé à un graphique représentant l'intensité des données affichées,
- la figure 4 illustre schématiquement une vue partielle en coupe, d'un véhicule dans lequel les lunettes sont utilisées.

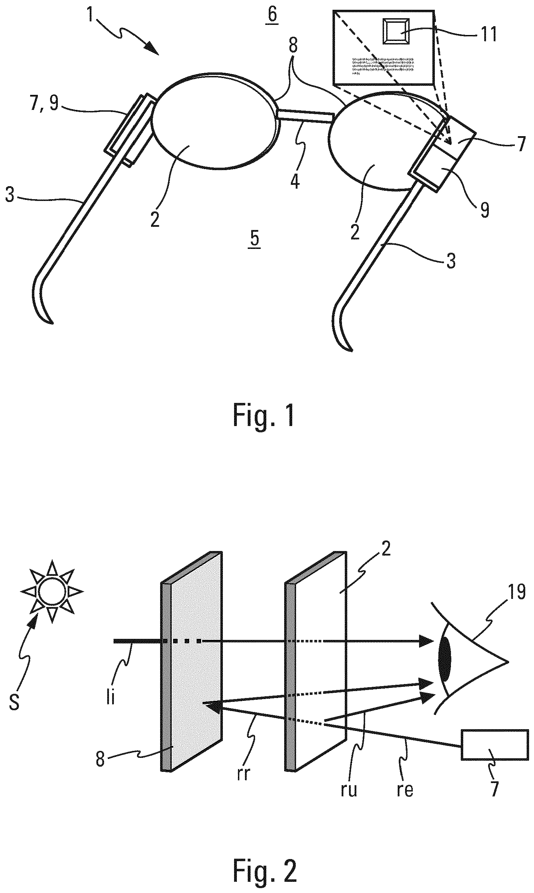

Comme illustré aux figures 1 et 2, les lunettes 1 selon l'invention ont ici deux verres 2, deux branches 3 et une monture 4 sur laquelle sont fixés les verres 2. Dans la description de l'invention, le terme verre désigne l'objet fixé à la monture et à travers lequel le porteur des lunettes regarde la scène qui est devant lui. Le verre 2 peut être fabriqué dans un matériau en verre minéral ou organique par exemple, mais aussi dans tout autre matériau connu de l'homme du métier à cette fin.

Le porteur des lunettes 1 est situé d'un premier côté des verres 2, et la scène qu'il observe est située d'un deuxième côté des verres 2. Ainsi, la lumière incidente li arrive sur les verres 2 en venant du deuxième côté, puis les traverse par la face extérieure des verres, et ressort par la face intérieure vers le porteur des lunettes.

Les lunettes 1 comprennent des moyens d'affichage 7 de données en direction d'un champ de vision de l'utilisateur. Lesdits moyens d'affichage sont configurés pour émettre des rayons re permettant l'affichage des données.

L'image contenant lesdites données se forme avantageusement au niveau d'un support virtuel, placé à quelques mètres ou à l'infini de façon à avoir une taille suffisante d'affichage desdites données.

Les moyens d'affichage 7 de données sont configurés pour transmettre lesdits rayons à l'aide du verre. Les moyens d'affichage 7 comprennent alors, par exemple, une source de lumière telle qu'un générateur d'images apte à émettre dans le verre 2, et un substrat de transmission de sorte à guider les rayons re par réflexion interne dans le verre.

Les lunettes comportent en outre un écran anti-éblouissement 8. Lesdits moyens d'affichage 7 et ledit écran anti-éblouissement 8 sont positionnés les uns par rapport aux autres, de manière à ce que les rayons émis par lesdits moyens d'affichage 7 pour afficher lesdites données, rencontrent ledit écran anti-éblouissement 8. Par exemple, l'écran anti-éblouissement 8 est disposé du deuxième côté du verre 2, par exemple sur la face extérieure des verres, de l'autre côté de l'utilisateur par rapport aux lunettes.

Pour diminuer l'éblouissement, l'écran anti-éblouissement 8 est muni d'un coefficient de transmission variable permettant d'atténuer l'intensité de la lumière incidente. Selon la valeur du coefficient de transmission, l'écran anti-éblouissement 8 laisse passer une partie plus ou moins importante de la lumière incidente.

Le coefficient de transmission est déterminé par modulation de largeur d'impulsions. La modulation est effectuée à fréquence fixe, de préférence à au moins 100 Hz, avec un rapport cyclique définissant le coefficient de transmission de l'écran.

L'écran anti-éblouissement 8 a donc un coefficient de transmission de la lumière qui varie périodiquement entre :

- une valeur maximale, pour laquelle la transparence est maximale pendant un temps t1, et
- une valeur minimale, pour laquelle la transparence est minimale pendant un temps t2.

Un rapport cyclique $\alpha$ est déterminé par le ratio entre la durée t1 pendant laquelle la transmission est maximale, et la durée T de la période, et varie donc de 0 à 100%:

$$\alpha = \frac{t_1}{T}$$

En modifiant le rapport cyclique, le temps t1 pendant lequel la transparence est maximale est allongé ou raccourci, par rapport au temps t2 pendant lequel la lumière ne passe pas. Ainsi, en augmentant t1, le rapport cyclique augmente, et en augmentant t2, le rapport cyclique diminue. En valeur moyenne, le coefficient de transmission est ainsi dépendant de la valeur du rapport cyclique $\alpha$.

La scène située devant le porteur des lunettes 1 n'est donc visible que pendant une fraction de temps égale au rapport cyclique $\alpha$. La luminosité apparente, à travers l'écran 8 à transmission variable, est donc diminuée par rapport à la luminosité réelle d'un facteur égal à $(1-\alpha)$.

En outre, lesdites lunettes 1 sont configurées pour adapter le coefficient de transmission de l'écran 8 en fonction de l'intensité de la lumière incidente. Les lunettes permettent de la sorte, en plus d'afficher des données pour l'utilisateur, de le protéger d'une luminosité importante. Par conséquent, l'utilisateur peut lire les données affichées même par forte luminosité. Ainsi, le couplage d'une paire de lunettes à affichage de données et d'un système anti-éblouissement permet de conserver un contraste suffisant des informations affichées, indépendamment du niveau lumineux ou du niveau d'éblouissement de la scène devant laquelle le porteur desdites lunettes se trouve.

Pour cela, les lunettes 1 comprennent ici des moyens de commande 9 du coefficient de transmission, soit en valeur instantanée, soit en valeur moyenne. Par exemple, en choisissant un rapport cyclique déterminé, on définit un coefficient de transmission correspondant.

Ainsi, le rapport cyclique est variable et choisi en fonction de l'intensité lumineuse de la lumière incidente. Afin de mesurer l'intensité lumineuse de la lumière incidente, les lunettes 1 pourront comprendre un capteur de luminosité, non représenté, qui fournit la mesure aux moyens de commande 9. Les moyens de commande 9 déterminent la valeur du rapport cyclique en fonction de cette mesure.

Dans un premier mode de réalisation, l'écran anti-éblouissement 8 est muni d'une couche à polarisation verticale et d'une couche à polarisation horizontale, disposées sur le verre, ainsi qu'une couche à cristaux-liquides agencée entre les deux couches de polarisation. Les couches de polarisation polarisent chacune la lumière incidente dans une direction différente. Dans la couche à cristaux-liquides, la direction de la lumière polarisée est modifiée par les cristaux liquides. L'orientation des cristaux liquides détermine la direction de polarisation de la lumière. Ainsi lorsqu'ils sont orientés dans un sens qui modifie la polarisation dans une même direction que celle de la couche de polarisation qui suit, la lumière passe au travers. En revanche, si la direction est différente, la lumière n'est pas transmise au porteur des lunettes 1.

La modulation est effectuée en orientant les cristaux liquides dans la même direction que celle de la couche de polarisation suivante pendant le temps t1, pour transmettre la lumière, puis en l'orientant dans une direction différente pendant le temps t2, pour bloquer la lumière.

Dans un second mode de réalisation, l'écran anti-éblouissement 8 est muni d'une couche micro-électromécanique de type MEMS (pour micro-electro-mechanical system en anglais), disposée sur le verre 2. Cette couche est composée d'éléments microélectroniques actionnables électriquement, qui bloquent ou laissent passer la lumière incidente. Les systèmes micro électromécaniques, sont par exemple du type décrit dans le document US 7 684 105. Ici, la modulation est effectuée en laissant passer la lumière incidente pendant le temps t1, et en la bloquant pendant le temps t2, par actionnement de la couche micro-électromécanique.

Sur la figure 2, on observe que la lumière incidente li traverse d'abord l'écran anti-éblouissement 8 puis le verre 2 pour arriver à l'œil 19 de l'utilisateur. Le coefficient de transmission de l'écran anti-éblouissement 8 permet de diminuer l'intensité de la lumière incidente li pour le confort de l'utilisateur. Simultanément, les moyens d'affichage 7 projettent les rayons re qui arrivent en premier sur le verre 2. L'affichage des données sur le verre 2 engendre des rayons ru vers l'utilisateur lui permettant de percevoir les données. D'autres rayons rr, sont transmis en direction de l'écran anti-éblouissement 8, et sont réfléchis au moins en partie, vers l'œil 19 de l'utilisateur à travers le verre 2. Par conséquent, une deuxième image des données est susceptible de s'afficher sur le verre 2 avec un décalage par rapport à l'image normale.

Pour éviter cette réflexion, les moyens d'affichage 7 et l'écran anti-éblouissement 8 sont couplés de sorte que les moyens d'affichage 7 affichent des données lorsque l'écran anti-éblouissement 8 transmet la lumière, c'est-à-dire pendant le temps t1 du rapport cyclique. Ainsi, lorsque l'écran anti-éblouissement 8 ne transmet pas la lumière pendant le temps t2 du rapport cyclique, les moyens d'affichage 7 n'affichent pas de données, afin de limiter une réflexion sur l'écran anti-éblouissement 8 qui ne transmet pas la lumière pendant le temps t2.

Selon un mode de réalisation particulier, l'intensité lumineuse des données affichées est aussi déterminée par modulation de largeur d'impulsions avec un rapport cyclique variable et une fréquence fixe. Les données apparaissent seulement pendant le temps t1 à une intensité donnée de référence, les moyens d'affichage 7 n'affichant pas de données sur la zone d'affichage 11 pendant le temps t2. L'intensité des données est contrôlée en faisant varier le coefficient $\alpha$, en augmentant ou diminuant le temps d'affichage t1 par rapport à une durée $T$ de période constante. Dans ce cas, les moyens de commande 9 commandent aussi le rapport cyclique de l'intensité lumineuse des données.

Pour corréler l'intensité lumineuse des données et le coefficient de transmission, l'intensité lumineuse et le coefficient de transmission sont en phase avec un ratio $\alpha$ identique. Ainsi, les données sont affichées lorsque l'écran anti-éblouissement 8 laisse passer la lumière, et ne le sont pas si l'écran anti-éblouissement 8 est opaque. Néanmoins, l'intensité de référence pourra être adaptée pour garder une intensité perçue semblable quelle que soit le ratio $\alpha$. Ainsi, si le temps t1 augmente à cause d'une faible luminosité, l'intensité de référence est diminuée proportionnellement. De façon identique, si le temps t1 diminue à cause d'une forte luminosité, l'intensité de référence est augmentée proportionnellement.

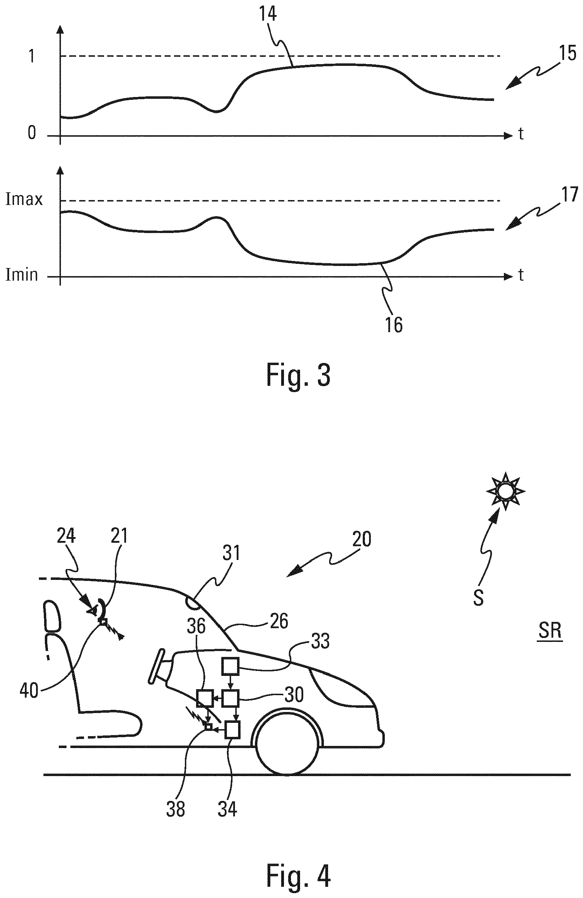

En variante, l'intensité d'affichage des moyens d'affichage 7 pourra être corrélée à la valeur du coefficient de transmission de l'écran anti-éblouissement 8 dans le but de conserver la même quantité de lumière en provenance des données affichées, et qui arrivent à l'œil du porteur des lunettes 1. Pour cela, l'intensité lumineuse 16 des données affichées est modifiée de façon inversement proportionnelle au coefficient de transmission 14, afin d'obtenir une perception similaire des données par l'utilisateur, quelle que soit la lumière incidente, comme cela est représenté sur la figure 3, où deux graphiques 15, 17 sont superposés. Sur le graphique 15, le coefficient de transmission 14 varie entre 0 et 1 au cours du temps t. Sur le graphique 17, l'intensité lumineuse 16 varie entre une valeur minimale Imin et une valeur maximale Imax au cours du temps t. Lorsque la transmission de l'écran anti-éblouissement augmente, l'intensité lumineuse des données diminue proportionnellement, et réciproquement.

Autrement dit, les lunettes permettent simultanément une adaptation du coefficient de transmission de l'écran en fonction de l'intensité de la lumière incidente pour que le porteur des lunettes ne soit pas ébloui, et une adaptation de l'intensité lumineuse des données affichées sur la zone d'affichage en fonction du coefficient de transmission de l'écran, afin que ces données soient perceptibles de façon semblable quelle que soit la situation.

Dans une application spécifique décrite ci-dessous, les lunettes 1 sont utilisées comme dispositif d'aide à la conduite d'un véhicule automobile 20. Cette application est développée à titre d'exemple, mais ne limite pas l'application des lunettes 1 de l'invention à cet exemple.

Sur la figure 4, est représenté ce dispositif d'aide à la conduite utilisant des lunettes 21 conformes à l'invention, sans que cette application doive être considérée comme limitative.

On voit que par temps ensoleillé, notamment en fin de journée lorsque la hauteur du soleil S sur l'horizon est faible, la scène de route SR en avant du véhicule 20 est fortement éclairée. Le conducteur 24 risque donc non seulement d'être ébloui, mais peut aussi ne pas distinguer des détails de cette scène de route importants pour sa sécurité, par exemple des panneaux de signalisation avertissant de la proximité d'un danger, ou l'état de la chaussée sur laquelle il circule. Il en est de même pour la circulation nocturne, pendant laquelle le conducteur peut être ébloui par les feux des autres véhicules.

Les lunettes 21 servent alors à protéger le conducteur ou les passagers qui les portent, contre toute forme d'éblouissement ou de variation importante de l'intensité lumineuse incidente. Cependant, le conducteur 24 doit par exemple, avoir accès visuellement aux informations de pilotage, telles que celles affichées habituellement sur le tableau de bord, et qui ne sont pas accessibles si le coefficient de transmission en valeur moyenne est faible. Grâce à l'invention, ces informations sont directement affichées sur les lunettes 21, avec une intensité lumineuse déterminée pour qu'elles soient visibles par le porteur des lunettes 21.

L'invention prévoit donc dans cette application, de munir le conducteur 24 d'une paire de lunettes 21 adaptatives pour moduler la quantité de lumière atteignant l'œil du conducteur 19, et lui présenter simultanément des informations. Un seul verre de lunette a été représenté pour la clarté du dessin.

En outre, ce dispositif comprend des moyens de commande 30 du coefficient de transmission, qui sont ici situés à distance des lunettes 21. Lesdits moyens de commande 30 sont par exemple agencés dans l'habitacle du véhicule 20, et communiquent les ordres de commande aux lunettes 21.

Pour la commande du coefficient de transmission des verres de lunettes 21, l'invention prévoit d'utiliser un capteur photosensible 31 de mesure de la luminosité de la scène de route SR en avant du véhicule.

Le capteur photosensible 31 est ici situé, par exemple, sur la face intérieure du pare-brise 26 du véhicule 20, au niveau du rétroviseur intérieur (non représenté), c'est-à-dire au milieu de la partie supérieure du pare-brise 26. Cette position permet de recueillir une information particulièrement représentative de la luminosité extérieure au véhicule 20, issue de la scène de route SR.

Le signal de sortie SL de ce capteur photosensible 31 est reçu et traité par un circuit 33 apte à transformer ce signal de sortie SL en un signal de commande SC du coefficient de transmission des verres de lunette 21, ce signal SC étant à son tour reçu par les moyens de commande 30 du coefficient de transmission des verres de lunette 21.

Les moyens de commande 30 pilotent un circuit 34 de commande du coefficient de transmission des verres de lunettes 21, qui comprend lui-même un émetteur 38 par exemple d'ondes radio, infrarouges ou ultrasonores selon un protocole de communication sans fil, par exemple selon les normes Bluetooth ou Wi-Fi (marques déposées). Les lunettes 21 sont pourvues d'un récepteur 40 de ces mêmes ondes de télécommande OT.

A cet effet, en réponse au signal de sortie SL du capteur photosensible 31, représentatif de la luminosité de la scène de route SR devant le véhicule 20, le circuit 33 génère un signal de commande SC, fonction du signal SL. Le signal de commande SC est alors transmis par l'émetteur 38 du circuit de commande 34, via les ondes OT et le récepteur 40, aux lunettes 21.

Le coefficient de transmission des verres de lunettes 21 va ainsi être modulé en fonction du signal SC reçu, c'est-à-dire en fonction de la luminosité mesurée par le capteur 31.

Le dispositif comprend aussi des moyens de génération 36 des données à afficher, qui pourront également être situés dans l'habitacle, à distance des lunettes 21. Lesdits moyens de génération 36 communiquent lesdites données aux lunettes 21.

La communication entre les moyens de génération 36 des données et les lunettes 21 est aussi effectuée par communication sans fil, par exemple selon le même protocole que celui employé par les moyens de commande 30 et les lunettes 21, éventuellement avec le même émetteur 38 et/ou le même récepteur 40.

Ainsi, les moyens de génération 36 transmettent les données avec un ordre d'intensité donné, déterminé en fonction du coefficient de transmission défini par les moyens de commande 30.

## Revendications

1.  Lunettes (1) munies d'au moins un verre (2) et configurées pour être portées par un utilisateur situé d'un premier côté du verre (2), lesdites lunettes (1) comprenant des moyens d'affichage (7) configurés pour projeter des données dans un champ de vision de l'utilisateur, et un écran anti-éblouissement (8) muni d'un coefficient de transmission variable configuré pour atténuer l'intensité d'une lumière incidente destinée à traverser le verre (2) vers ledit utilisateur, lesdits moyens d'affichage (7) et ledit écran anti-éblouissement (8) étant positionnés de manière à ce qu'une partie des rayons émis par lesdits moyens d'affichage (7) pour afficher lesdites données, rencontrent ledit écran anti-éblouissement (8), l'écran anti-éblouissement (8) étant disposé d'un deuxième côté du verre (2), la lumière incidente étant destinée à traverser le verre du deuxième côté du verre (2) vers le premier côté (6), lesdites lunettes (1) étant configurées pour adapter le coefficient de transmission de l'écran anti-éblouissement (8) en fonction de l'intensité de la lumière incidente, le coefficient de transmission étant déterminé par modulation de largeur d'impulsions avec un rapport cyclique déterminé, l'écran anti-éblouissement (8) ayant un coefficient de transmission de la lumière qui varie périodiquement entre une valeur maximale, pour laquelle la transparence est maximale pendant un temps t1, et une valeur minimale, pour laquelle la transparence est minimale pendant un temps t2 pendant lequel la lumière ne passe pas, **caractérisé en ce que** les moyens d'affichage (7) sont en outre couplés à l'écran anti-éblouissement (8) de sorte que les moyens d'affichage (7) affichent des données lorsque l'écran anti-éblouissement (8) transmet la lumière, et n'affichent pas de données lorsque l'écran anti-éblouissement (8) ne transmet pas la lumière.

2. Lunettes selon la revendication 1, dans lesquelles le couplage est produit en commandant l'intensité lumineuse (16) des données affichées en fonction du coefficient de transmission (14) de l'écran anti-éblouissement (8), l'intensité lumineuse (16) des données affichées étant modifiée de façon inversement proportionnelle au coefficient de transmission (14), afin d'obtenir une perception similaire des données par l'utilisateur quelle que soit la lumière incidente.

3. Lunettes selon l'une quelconque des revendications 1 à 2, dans lesquelles l'intensité lumineuse (16) des données affichées est déterminée par modulation de largeur d'impulsions avec un rapport cyclique déterminé.

4. Lunettes selon les revendications 1 à 3, dans lesquelles l'intensité lumineuse (16) et le coefficient de transmission (14) sont en phase et présentent le même rapport cyclique.

5. Lunettes selon l'une quelconque des 1 à 4, dans lesquelles la modulation est effectuée à fréquence fixe avec un rapport cyclique variable.

6. Lunettes selon l'une quelconque des revendication 1 à 5, dans lesquelles les lunettes (1) comprennent des moyens de commande (9) du ou des rapports cycliques.

7. Lunettes selon l'une quelconque des revendications précédentes, dans lesquelles l'écran anti-éblouissement (8) est porté par le verre (2).

8. Lunettes selon l'une quelconque des revendications précédentes, dans lequel ledit écran anti-éblouissement (8) est muni d'une couche micro-électromécanique, disposée sur le verre (2).

9. Lunettes selon la revendication 8, dans lesquelles la couche micro-électromécanique est activable pour bloquer ou transmettre la lumière.

10. Lunettes selon l'une quelconque des revendications précédentes, dans lesquelles lesdits moyen d'affichage (7) comportent un substrat de transmission de sorte à guider les rayons lumineux par réflexion interne dans le verre (2).

11. Lunettes selon la revendication 10, dans lesquelles les moyens d'affichage de données comprennent une source de lumière apte à émettre lesdits rayons lumineux dans le verre.

12. Lunettes selon l'une quelconque des revendications 1 à 9, dans lesquelles les moyens d'affichage (7) de données comprennent un générateur d'images.

13. Dispositif d'aide à la conduite, notamment nocturne, de véhicule automobile (20) comprenant des lunettes (1) selon l'une quelconque des revendications précédentes.

## Patentansprüche

1. Brille (1), die mit wenigstens einem Glas (2) versehen ist und dazu ausgebildet ist, von einem Benutzer getragen zu werden, der sich auf einer ersten Seite des Glases (2) befindet, wobei die Brille (1) Anzeigemittel (7), die dazu ausgebildet sind, Daten in ein Sichtfeld des Benutzers zu projizieren, und einen Blendschutzschirm (8) mit einem variablen Transmissionskoeffizienten umfasst, der dazu ausgebildet ist, die Intensität eines einfallenden Lichts zu dämpfen, das dazu bestimmt ist, das Glas (2) hin zum Benutzer zu durchqueren, wobei die Anzeigemittel (7) und der Blendschutzschirm (8) so positioniert sind, dass ein Anteil der Strahlen, die von den Anzeigemitteln (7) ausgesendet werden, um die Daten anzuzeigen, auf den Blendschutzschirm (8) treffen, wobei der Blendschutzschirm (8) auf einer zweiten Seite des Glases (2) angeordnet ist, wobei das einfallende Licht dazu bestimmt ist, das Glas von der zweiten Seite des Glases (2) hin zur ersten Seite (6) zu durchqueren, wobei die Brille (1) dazu ausgebildet ist, den Transmissionskoeffizienten des Blendschutzschirms (8) je nach der Intensität des einfallenden Lichts anzupassen, wobei der Transmissionskoeffizient durch Pulsbreitenmodulation mit einem bestimmten Tastverhältnis bestimmt wird, wobei der Blendschutzschirm (8) einen Transmissionskoeffizienten des Lichts aufweist, der periodisch zwischen einem Maximalwert, für den die Transparenz während einer Zeit t1 maximal ist, und einem Minimalwert variiert, für den die Transparenz während einer Zeit t2 minimal ist, während welcher das Licht nicht hindurchgeht, **dadurch gekennzeichnet, dass** die Anzeigemittel (7) ferner so an den Blendschutzschirm (8) gekoppelt sind, dass die Anzeigemittel (7) Daten anzeigen, wenn der Blendschutzschirm (8) das Licht hindurchlässt, und keine Daten anzeigen, wenn der Blendschutzschirm (8) das Licht nicht hindurchlässt.

2. Brille nach Anspruch 1, wobei die Kopplung herbeigeführt wird, indem die Lichtintensität (16) der angezeigten Daten in Abhängigkeit vom Transmissionskoeffizienten (14) des Blendschutzschirms (8) gesteuert wird, wobei die Lichtintensität (16) der angezeigten Daten umgekehrt proportional zum Transmissionskoeffizienten (14) verändert wird, um eine ähnliche Wahrnehmung der Daten durch den Benutzer ganz gleich bei welchem einfallenden Licht zu erzielen.

3. Brille nach einem der Ansprüche 1 bis 2, wobei die Lichtintensität (16) der angezeigten Daten durch Pulsbreitenmodulation mit einem bestimmten Tastverhältnis bestimmt wird.

4. Brille nach den Ansprüchen 1 bis 3, wobei die Lichtintensität (16) und der Transmissionskoeffizient (14) phasengleich sind und dasselbe Tastverhältnis aufweisen.

5. Brille nach einem der Ansprüche 1 bis 4, wobei die Modulation bei fester Frequenz mit einem variablen Tastverhältnis vorgenommen wird.

6. Brille nach einem der Ansprüche 1 bis 5, wobei die Brille (1) Mittel zur Steuerung (9) des oder der Tastverhältnisse umfasst.

7. Brille nach einem der vorhergehenden Ansprüche, wobei der Blendschutzschirm (8) vom Glas (2) getragen wird.

8. Brille nach einem der vorhergehenden Ansprüche, wobei der Blendschutzschirm (8) mit einer mikroelektromechanischen Schicht versehen ist, die auf dem Glas (2) angeordnet ist.

9. Brille nach Anspruch 8, wobei die mikroelektromechanische Schicht aktivierbar ist, um das Licht zu blockieren oder hindurchzulassen.

10. Brille nach einem der vorhergehenden Ansprüche, wobei die Anzeigemittel (7) ein Transmissionssubstrat aufweisen, damit die Lichtstrahlen durch innere Reflexion im Glas (2) geleitet werden.

11. Brille nach Anspruch 10, wobei die Mittel zur Anzeige von Daten eine Lichtquelle umfassen, die geeignet ist, die Lichtstrahlen in das Glas auszusenden.

12. Brille nach einem der Ansprüche 1 bis 9, wobei die Mittel zur Anzeige (7) von Daten einen Bildgenerator umfassen.

13. Assistenzvorrichtung zum Fahren, insbesondere bei Nacht, eines Kraftfahrzeugs (20), umfassend eine Brille (1) nach einem der vorhergehenden Ansprüche.

**Claims**

1. Spectacles (1) equipped with at least one lens (2) and configured to be worn by a user located on a first side of the lens (2), said spectacles (1) comprising displaying means (7) configured to project data into a field of view of the user, and an anti-glare screen (8) provided with a variable transmission coefficient configured to attenuate the intensity of incident light intended to pass through the lens (2) toward said user, said displaying means (7) and said anti-glare screen (8) being positioned so that some of the rays emitted by said displaying means (7), in order to display said data, strike said anti-glare screen (8), the anti-glare screen (8) being placed on a second side of the lens (2), the incident light being intended to pass through the lens from the second side of the lens (2) to the first side (6), said spectacles (1) being configured to adapt the transmission coefficient of the anti-glare screen (8) depending on the intensity of the incident light, the transmission coefficient being determined by pulse width modulation with a determined duty cycle, the anti-glare screen (8) having a light transmission coefficient that varies periodically between a maximum value, for which transparency is maximum for a time $t_1$, and a minimum value, for which transparency is minimum for a time $t_2$ during which light does not pass, **characterized in that** the displaying means (7) are further coupled to the anti-glare screen (8) in such a way that the displaying means (7) display data when the anti-glare screen (8) transmits light, and do not display data when the anti-glare screen (8) does not transmit light.

2. Spectacles according to Claim 1, in which the coupling is produced by controlling the light intensity (16) of the displayed data depending on the transmission coefficient (14) of the anti-glare screen (8), the light intensity (16) of the displayed data being modified inversely proportionally to the transmission coefficient (14), in order to obtain a similar perception of the data by the user whatever the amount of incident light.

3. Spectacles according to either one of the Claims 1 and 2, in which the light intensity (16) of the displayed data is determined by pulse width modulation with a determined duty cycle.

4. Spectacles according to Claims 1 to 3, in which the light intensity (16) and the transmission coefficient (14) are in phase and have the same duty cycle.

5. Spectacles according to any one of Claims 1 to 4, in which the modulation is carried out at fixed frequency with a variable duty cycle.

6. Spectacles according to any one of Claims 1 to 5, in which the spectacles (1) comprise means (9) for controlling the duty cycle or duty cycles.

7. Spectacles according to any one of the preceding claims, in which the anti-glare screen (8) is borne by the lens (2).

8. Spectacles according to any one of the preceding claims, in which said anti-glare screen (8) is equipped with a microelectromechanical layer placed on the lens (2) .

9. Spectacles according to Claim 8, in which the microelectromechanical layer is actuatable to block or transmit light.

10. Spectacles according to any one of the preceding claims, in which said displaying means (7) comprise a transmitting substrate so as to guide the light rays by internal reflection in the lens (2).

11. Spectacles according to Claim 10, in which the means for displaying data comprise a light source able to emit said light rays into the lens.

12. Spectacles according to any one of Claims 1 to 9, in which the means (7) for displaying data comprise an image generator.

13. Device for assisting with driving, especially at night, a motor vehicle (20), comprising spectacles (1) according to any one of the preceding claims.

Fig. 1

Fig. 2

Fig. 3

Fig. 4

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2013113973 A
- US 2008218434 A
- JP 2004233908 A
- US 7684105 B